Europäisches Patentamt

European Patent Office

Office européen des brevets

(11) Veröffentlichungsnummer: **0 324 146 B1**

# EUROPÄISCHE PATENTSCHRIFT

(45) Veröffentlichungstag der Patentschrift: **29.07.92**

(51) Int. Cl.⁵: **H02P 5/40**, H02P 7/62

(21) Anmeldenummer: **88121422.5**

(22) Anmeldetag: **21.12.88**

(54) Verfahren und Vorrichtung zur Bestimmung des Läuferwiderstandes einer Drehfeldmaschine.

(30) Priorität: **14.01.88 DE 3800915**

(43) Veröffentlichungstag der Anmeldung:
**19.07.89 Patentblatt 89/29**

(45) Bekanntmachung des Hinweises auf die Patenterteilung:
**29.07.92 Patentblatt 92/31**

(84) Benannte Vertragsstaaten:
**CH DE FR GB IT LI SE**

(56) Entgegenhaltungen:
**EP-A- 0 228 535**
**DE-A- 3 430 386**

**PESC'85 RECORD, 16TH ANNUAL IEEE POWER ELECTRONICS SPECIALISTS CONFERENCE, 24.-28. Juni 1985, Toulouse, Seiten 751-760, IEEE, New York, US; G.C. VERGHESE et al.: "Observers for faster flux estimation in induction machines"**

(73) Patentinhaber: **SIEMENS AKTIENGESELLSCHAFT**
**Wittelsbacherplatz 2**
**W-8000 München 2(DE)**

(72) Erfinder: **Schmidt, Rolf, Dipl.-Ing.**
**Paul-Gossen-Strasse 119**
**W-8520 Erlangen(DE)**
Erfinder: **Schierling, Hubert, Dr.**
**Ahornweg 2d**
**W-8520 Erlangen(DE)**

**Beschreibung**

Die Erfindung betrifft ein Verfahren zum Ermitteln des Läuferwiderstandes einer Drehfeldmaschine, insbesondere im Stillstand oder bei niedriger Last, mittels eines von Stromwerten und Spannungswerten gespeisten Spannungsmodells und eines mit Stromwerten und die Läuferachse beschreibenden Signalen und einem Modell-Parameter für den Läuferwiderstand der Maschine gespeisten Strommodell für die Maschine. Die Erfindung betrifft ferner eine Vorrichtung zur Durchführung des Verfahrens.

Für die feldorientierte Steuerung oder Regelung hochdynamischer moderner Drehfeldmaschinen wird eine Information über die Lage der Feldachse benötigt. Um den Einbau eigener Meßsonden in der Maschine zu vermeiden, werden häufig Rechenmodelle verwendet, die die mit dem Fluß verknüpften physikalischen Vorgänge der Maschine aus einfach zugänglichen Meßgrößen berechnen.

So kann z.B. aus der Maschinenspannung der diese Spannung induzierende Fluß ermittelt werden. Im einzelnen ergibt die Spannung unter Abzug des mit einem Parameter $r_S$ für den Ständerwiderstand behafteten ohmschen Spannungsabfalls und des mit einem Parameter $x_{st}$ für die Streuinduktivität behafteten Streuspannungsabfalls die im Läufer induzierte EMK, deren Integral der Fluß im Läufer der Maschine ist. Bei einem derartigen "Spannungsmodell" kann häufig auf die Integration der EMK verzichtet werden, da diese lediglich eine Drehstrekkung um 90° darstellt. Bei niedrigen Drehzahlen arbeitet jedoch das Spannungsmodell nicht zufriedenstellend.

Im sogenannten "Strommodell" wird von den in die Maschine eingespeisten Strömen und der Stellung der Läuferachse ausgegangen, um unter Berücksichtigung des Läuferwiderstandes den im Läufer induzierten Fluß zu berechnen. Der Läuferwiderstand selbst ändert sich jedoch in Abhängigkeit von der Betriebstemperatur, ohne dabei einer direkten Messung zugänglich zu sein. Dies verfälscht den im Strommodell errechneten Wert der Flußachse.

In der Deutschen Offenlegungsschrift 34 30 386 ist ein Verfahren zum Betrieb einer Drehfeldmaschine beschrieben, bei dem der Feldwinkel mittels des Spannungsmodells ermittelt wird, das Spannungsmodell selbst mittels eines Strommodells korrigiert wird. Der im Strommodell verwendete Läuferwiderstandsparameter ist dabei regelbar.

Zu dieser Parameterregelung wird in der feldorientierten Regelung dem Sollwert für den Magnetisierungsstrom eine Kette von Rechteckimpulsen aufgeschaltet. In der Maschine treten daher entsprechende impulsförmige Änderungen des Magnetisierungsstroms auf, die mit einer durch die Zeitkonstante des Läufers hervorgerufenen Glättung eine entsprechende periodische Änderung des Flusses bzw. der EMK bewirken. Der Betrag des im Strommodell errechneten EMK-Vektors oder Flußvektors verändert sich mit einer anderen Zeitkonstanten als der im Spannungsmodell errechnete Vektorbetrag, so daß vorübergehend eine Betragsdifferenz auftritt, die von der Fehleinstellung des Läuferwiderstandsparameters abhängt. Daher wird die mit dem Zusatz-Sollwert korrelierte Betragsdifferenz erfaßt und durch Verstellen des Läuferwiderstandsparameters ausgeregelt.

Bei diesem bekannten Verfahren würde ein Zusatzsollwert mit harmonischem Verlauf und einer hohen Frequenz dazu führen, daß sich der Fluß in der Maschine nur schwach ändert und daher der Parameterfehler, der in die unterschiedliche Dynamik der beiden Vektorbeträge eingeht, nicht ausreichend genau identifiziert werden kann. Daher sind merkliche periodische Änderungen des Flusses unvermeidlich, die zwar nicht den Wirkstrom beeinflussen, aber das Drehmoment, das durch das Produkt aus Wirkstrom und Fluß gegeben ist.

Der Erfindung liegt daher die Aufgabe zugrunde, auf eine andere Weise den Läuferwiderstand einer Drehfeldmaschine zu identifizieren.

Diese Aufgabe wird gelöst durch ein Verfahren mit den Merkmalen des Anspruchs 1 bzw. eine Vorrichtung mit den Merkmalen des Anspruchs 7. Vorteilhafte Weiterbildungen der Erfindung sind in den Unteransprüchen gekennzeichnet.

Anhand von zwei Ausführungsbeispielen und 5 Figuren wird die Erfindung näher erläutert. Es zeigen:

Figur 1 einen feldorientierten Antrieb einer Drehfeldmaschine mit einer Vorrichtung gemäß der Erfindung,

Figur 2 das Prinzip eines Spannungsmodells,

Figur 3 das Prinzip eines Strommodells,

Figur 4 die Auswerteeinrichtung bei der Anordnung nach Fig. 1, und

Figur 5 eine andere Auswerteeinrichtung mit einem Frequenzgeber für die Erzeugung einer Hochfrequenzkomponente.

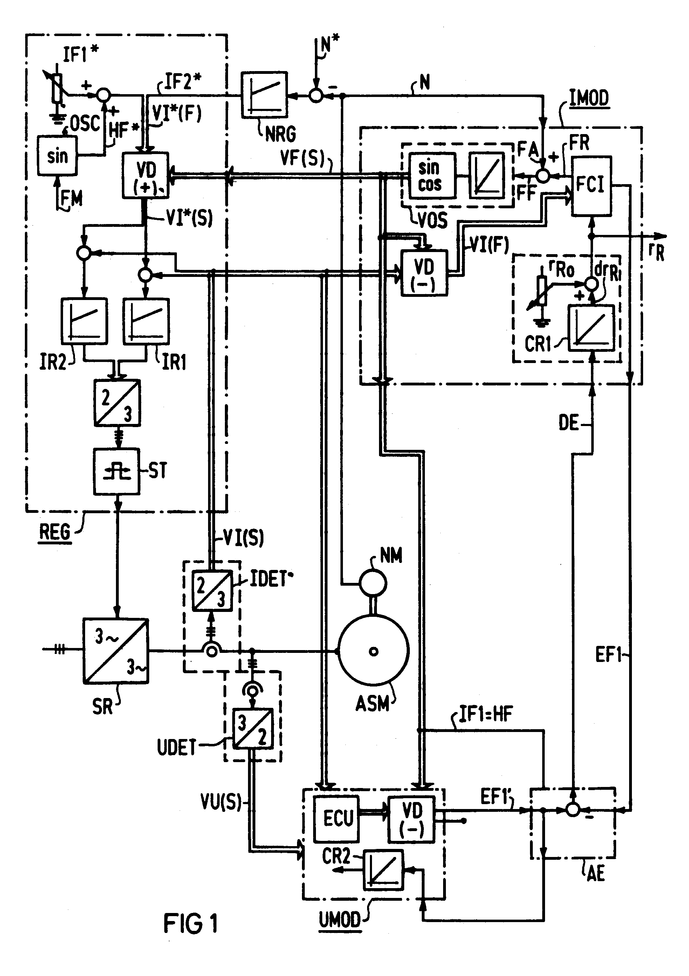

In Figur 1 ist am Beispiel einer Asynchronmaschine ASM, deren Ständerwicklungen von einem Stromrichter SR gespeist werden, das Prinzip einer feldorientierten Regelung dargestellt. In der entsprechenden Regeleinrichtung REG wird ein feldorientierter Strom-Sollvektor VI* (F) vorgegeben, dessen zur Feldachse parallele Komponente IF1* entsprechend einem gewünschten Flußbetrag eingegeben wird, während die feldsenkrechte Komponente IF2* den gewünschten Wirkstrom angibt und z.B. am Ausgang eines Drehzahlreglers NRG abgegriffen werden kann, der die mittels eines Drehzahlgebers NM gemessene Drehzahl N auf einem vorgegebenen Sollwert N* hält.

Der Stromrichter SR wird von den Steuerimpulsen eines Steuersatzes ST gesteuert, dessen Steuerspannungen durch eine Kombination von Koordinatenwandlungen und einer unterlagerten Stromregelung gebildet werden. Bei bestimmten Stromrichtern kann es auch erforderlich sein, eine unterlagerte Spannungsregelung anzuwenden.

Die feldorientierte Regeleinrichtung REG besitzt einen Eingang für ein die relative Lage der Feldachse bezüglich des Ständers beschreibendes Signal. Vektorielle Signale sind in den Figuren als Doppelpfeile dargestellt, da sie vorteilhaft aus zwei Einzelsignalen bestehen, die den beiden kartesischen Komponenten des betreffenden Vektors in einem orthogonalen Bezugsystem entsprechen. Die Feldachse kann durch einen entsprechenden ständerbezogenen Vektor VF(S) dargestellt werden, dessen Komponenten in einem Ständerbezugssystem durch den Cosinus und den Sinus des Winkels WF zwischen der Feldachse und einer Achse des Ständerbezugssystems gegeben sind. Mittels derartiger Winkelfunktionen können vektorielle Größen in einem sogenannten "Vektordreher" leicht von einem Koordinatensystem aufs andere umgerechnet werden. Im vorliegenden Fall wird mittels eines entsprechenden Vektordrehers VD( + ) der im feldorientierten Koordinatensystem vorgegebene Strom-Sollvektor VI*(F) in den entsprechenden Strom-Sollvektor VI*(S) im Ständerbezugssystem umgerechnet. Ein Stromdetektor IDET, der die an den Ständerzuleitungen gemessenen Phasenströme in die kartesischen Komponenten eines ständerbezogenen Iststrom-Vektors VI(S) umrechnet, liefert die Istwerte für Stromkomponentenregler IR1 und IR2, deren Ausgangssignale nach einer 2/3-Wandlung drei Steuergrößen für die vom Stromrichter SR in die Ständerwicklung einzuspeisenden Ständerströme liefert.

Diese Regeleinrichtung REG erzwingt somit die Gleichheit des Soll-Stromvektors mit dem Ist-Stromvektor dadurch, daß jeweils die Regeldifferenz einer ständerbezogenen Komponente ausgeregelt wird. Natürlich kann diese vektorielle Regelung auch in einem anderen Koordinatensystem erfolgen; z.B. kann der Iststromvektor VI(S) mittels des vektoriellen Signals VF(S) in das feldorientierte Koordinatensystem transformiert und dort mit dem feldorientierten Vektor VI*(F) verglichen werden, wobei dann die entsprechenden Stromregler die feldorientierten Komponenten eines Steuervektors bilden, der anschließend mittels des Vektors VF(S) ins Ständerbezugssystem rücktransformiert werden kann.

Die Bildung des Vektors VF(S) führt zu der der Erfindung zugrunde liegenden Aufgabe. Im vorliegenden Fall wird er an einem Strommodell, d.h. einer Rechenschaltung IMOD, abgegriffen und ein Spannungsmodell, d.h. eine entsprechende Rechenschaltung UMOD korrigiert eine mögliche Fehlberechnung des Vektors VF(S), die durch eine Fehljustierung des verwendeten Läuferwiderstandsparameters $r_R$ entsteht. Im Fall der DE-OS 34 30 386 ist der Vektor VF(S) am Spannungsmodell abgegriffen, wobei ein Fehler des Spannungsmodells durch Verwendung des Strommodells korrigiert wird. Auch in diesem Fall benötigt das Strommodell einen hinreichend genauen Wert für den Läuferwiderstandsparameter, dessen Identifikation Gegenstand der Erfindung ist.

Im vorliegenden Fall enthält das Strommodell einen im feldorientierten Koordinatensystem arbeitenden Flußrechner FCI, der zumindest die Differenzfrequenz FR zwischen der Frequenz des errechneten Modell-Flusses und der Frequenz N des Läufers bestimmt. FR entspricht daher einem Modellwert für die Schlupffrequenz, aus dem ein Frequenzaddierer FA die Frequenz FF des Feldes bezüglich des Ständers ermittelt. Ein Vektoroszillator VOS bildet daraus die beiden Komponenten des die errechnete Modell-Flußachse beschreibenden Vektors VF(S), die somit durch cos ($\int$FF . dt) und sin ($\int$FF . dt) gegeben sind. Eingangsgröße des Strommodells IMOD ist der Vektor des Ständerstroms: im vorliegenden Fall der ständerorientierte Ist-Stromvektor VI(S), der mittels eines Vektordrehers VD(-), dem die Modell-Flußachse VF(S) zugeführt ist, in das auf die Modell-Flußachse orientierte Koordinatensystem transformiert wird, um den entsprechenden feldorientierten Stromvektor VI(F) zu bilden. Sofern die unterlagerte Stromregelung hinreichend exakt arbeitet, kann anstatt des Ist-Stromvektors VI(F) auch der entsprechende Sollvektor VI*(F) verwendet werden.

Der Flußrechner FCI benötigt den Parameterwert $r_R$ für den Läuferwiderstand, der von einer Nachführeinrichtung geliefert wird, die einen Anfangswert $r_{R0}$ mittels des Ausgangssignals $dr_R$ eines Korrekturreglers CR1 korrigiert.

Der Eingang dieses Korrekturreglers CR1 ist an eine Auswerteeinrichtung AE angeschlossen, der die vom Flußrechner FCI des Strommodells IMOD errechnete, zur Modell-Flußachse VF(S) parallele Modell-Komponente EF1 sowie ein entsprechender, im Spannungsmodell UMOD errechneter Komponenten-Sollwert EF1' zugeführt sind.

Das Spannungsmodell UMOD enthält einen EMK-Rechner ECU, der im vorliegenden Fall ständerorientiert arbeitet und dem die ständerorientierten Vektoren VI(S) des Stromvektors und VU(S) des Spannungsvektors zugeführt sind. Die ständerorientierten kartesischen Komponenten des Spannungsvektors VU(S) werden von einem Spannungsdetektor UDET mittels eines 3/2-Wandlers aus den Phasenspannungen an den Zuleitungen der Ständerwicklung errechnet. Ferner ist im Spannungsmodell UMOD eine weitere Korrektureinrichtung (z.B.eine Korrekturregler CR2)vorgesehen, die einen korrigierten Wert für den Ständerwiderstand $R_S$ liefert. An den Ausgang des EMK-Rechners ECU ist ein weiterer, von VF(S) angesteuerter Vektordreher VD(-) angeschlossen, der den im Ständerbezugssystem errechneten EMK-Vektor in ein auf die Modell-Flußachse VF(S) orientiertes Koordinatensystem umrechnet. Von diesem transformierten, errechneten EMK-Vektor wird nur die zur Achse VF(S) parallele Komponente EF1' als entsprechender Sollwert für die Auswerteeinrichtung AE benötigt.

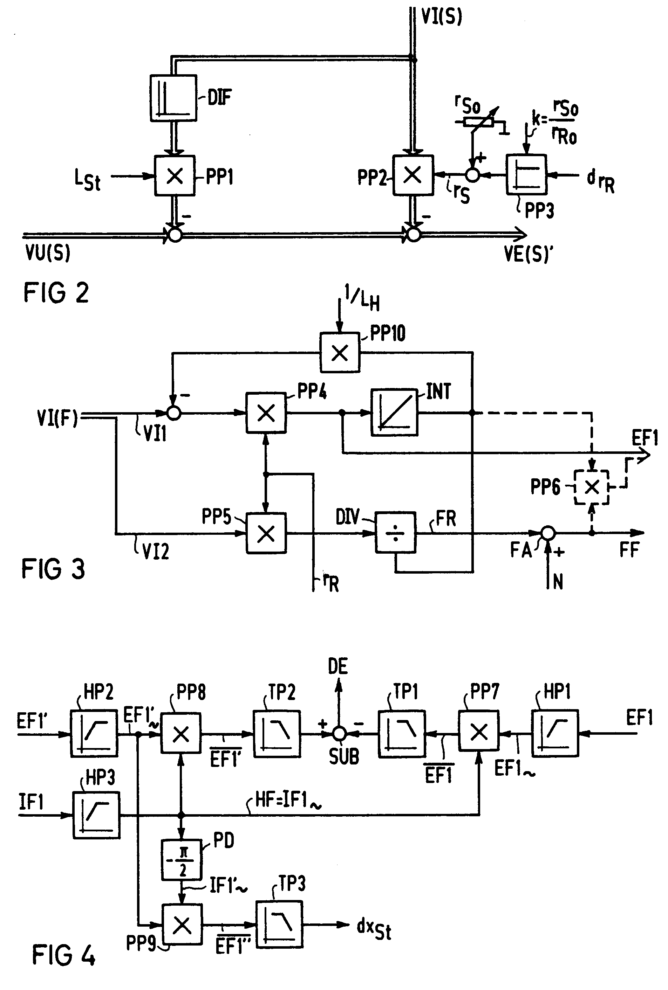

Figur 2 zeigt einen möglichen Aufbau des EMK-Rechners ECU, der den ständerbezogenen EMK-Vektor VE(S)' gemäß der vektoriellen Beziehung

$$VE(S)' = VU(S) - r_S. \, VI(S) - L_{St}. \, d(VI(S))/dt$$

errechnet, wozu die beiden Proportionalverstärker PP1, PP2 und das vom Vektor VI(S) beaufschlagte Differenzierglied DIF vorgesehen sind.

Eine fehlerhafte Einstellung des Ständerwiderstand-Parameters $r_S$ bewirkt einen Fehler im Komponentensollwert EF1', der mit einer Verstärkung $k_~$ in die Ermittlung von $r_R$ eingeht. Geht man von Parametern $r_{S0}$ und $r_{R0}$ für den Ständerwiderstand und vom Läuferwiderstand bei kalter Maschine aus, so erreicht man bei einer betriebsbedingten Erwärmung häufig einen genaueren Wert für den Ständerwiderstand $r_S$, wenn man diesen Wert proportional zur temperaturabhängigen Änderung $dr_R$ des Läuferwiderstandes erhöht. Als Proportionalitätsfaktor kann ungefähr der Quotient k aus den Gleichstromwiderständen $r_{S0}$ und $r_{R0}$ verwendet werden. Zu beachten ist aber, daß diese Identifikationsmethode an sich mit Wechselstromwiderständen arbeitet und deren Widerstandsverhältnis kleiner ist als das entsprechende Verhältnis der Gleichstromwiderstände. Eine Stromverdrängung wirkt sich bei höheren Frequenzen im Läufer stärker aus als im Ständer, so daß der Faktor $k_~$ geringer als k ist, der Einfluß der Temperaturerhöhung also weniger wirksam ist als im Gleichstromfall. Figur 2 zeigt die entsprechende Korrektureinrichtung, die durch einen Proportionalverstärker PP3 mit dem Verstärkungsfaktor k und die entsprechende Aufschaltung des Startwertes $r_{S0}$ für den Ständerwiderstand realisiert werden kann.

Figur 3 zeigt den Aufbau eines feldorientierten Strommodells, das aus der feldparallelen Komponente VI1 mittels eines Proportionalitätsgliedes PP4 und eines Integrators INT den Betrag des Flußvektors errechnet, der über ein Proportionalitätsglied PP10 mit einem zur Hauptfeldinduktivität $L_H$ reziproken Proportionalitätsfaktor auf den Eingang des Proportionalitätsgliedes PP4 gegengekoppelt ist. Die feldsenkrechte Komponente VI2 ist über ein Proportionalitätsglied PP5 einem Dividierer DIV zugeführt, in dem sie durch den Flußbetrag dividiert wird. Den Gliedern PP4 und PP5 ist der korrigierte Läuferwiderstandparameter $r_R$ als Proportionalitätsfaktor zugeführt und der Dividierer DIV liefert an seinem Ausgang die Schlupffrequenz FR, d.h. die Differenzfrequenz zwischen der Feldachse und der Läuferachse. Durch Addition mit der (auf elektrische Frequenzen umgerechneten) Drehzahl N kann daher die Frequenz FF der Feldachse im Ständerbezugssystem gebildet werden.

Da der Ausgang des Integrators INT den Flußbetrag, d.h. die feldparallele Komponente des Feldvektors selbst darstellt, liegt am Integratoreingang dessen zeitliche Ableitung, also die feldparallele Komponente EF1 des EMK-Vektors an und kann dort abgegriffen werden. Sofern auch die feldsenkrechte Komponente EF2 benötigt ist, kann sie durch einen Multiplizierer PP6 aus EF1 und der Frequenz FF gebildet werden.

Zur Identifizierung des Läuferwiderstandes wird dem Ständerstrom, der mittels des Sollstrom-Vektors der Maschine eingeprägt wird, eine sinusförmige Hochfrequenzkomponente HF überlagert. So kann z.B. eine Modulationsfrequenz FM von 80 Hz, also ein über der normalen Betriebsfrequenz liegender Wert, bereits als eine geeignete "Hochfrequenz" verwendet werden. Diese Hochfrequenz wird aber nur der parallel zur Modellachse VF(S) liegenden Komponente des Ständerstromvektors VI(S) eingeprägt. Diese Einprägung geschieht vorteilhaft dadurch, daß der entsprechenden feldparallelen Sollstromkomponente IF1* ein entsprechender sinusförmiger Zusatzsollwert HF* mittels eines Oszillators OSZ aufgeschaltet wird.

Figur 4 zeigt ein bevorzugtes erstes Ausführungsbeispiel der Auswerteeinrichtung AE, deren Aufgabe es ist, das Eingangssignal DE für den Korrekturregler CR1 zum Nachführen des Läuferwiderstandsparameters zu ermitteln. Dieser Korrekturregler verstellt den Modell-Parameter $r_R$ für den Läuferwiderstand der Maschine im Strommodell solange, bis die mit der Hochfrequenz-Komponente korrelierte Abweichung der Modell-Komponente EF1, die im Strommodell auf der Grundlage des Modell-Parameters $r_R$ errechnet wird, von dem Modellkomponenten-Sollwert,der im Spannungsmodell errechnet wird, auf den Wert Null ausgeregelt ist. Die mit der Hochfrequenzkomponente korrelierte Abweichung wird in dieser Auswerteeinrichtung aus den jeweils zur Hochfrequenzkomponente gleichphasigen Anteilen der Modell-Komponente und des Modellkomponenten-Sollwertes gebildet.

Dazu werden zunächst in Hochpaßfiltern HP1, HP2 der Hochfrequenz-Anteil in den beiden Komponenten EF1, EF1' von evtl.vorhandenen Gleichspannungsanteilen oder Anteilen, die sich mit der Frequenz FF der Modell-Flußachse verändern, isoliert. Die mit der Hochfrequenz-Komponente gleichphasigen Anteile $\overline{EF1},\overline{EF1'}$ dieser isolierten Hochfrequenz-Komponenten $EF1_\sim,EF1'_\sim$ können auf einfache Weise dadurch gebildet werden, daß die Hochfrequenzanteile der Modell-Komponente und des Modell-Komponentensollwertes mit der in der zur Modell-Flußachse parallelen Komponente IF1 des eingeprägten Stromes enthaltenen Hochfrequenzkomponente $IF1_\sim$ gebildet werden. Dies geschieht durch die Multiplizierer PP7 und PP8, die mit der in einem weiteren Hochpaßfilter HP3 isolierten Hochfrequenz-Komponente $IF1_\sim$ beaufschlagt sind. Die dadurch erhaltenen Produkte $IF1_\sim \cdot EF1_\sim$ und $IF1_\sim \cdot EF1'_\sim$ werden in Tiefpaßfiltern TP1 und TP2 geglättet, um mittels eines Subtraktionsgliedes SUB die Regeldifferenz DE des Korrekturreglers CR1 zu ermitteln.

Die Auswerteeinrichtung AE ermöglicht auch die Identifizierung des der Streuinduktivität entsprechenden Parameters $x_{St}$ im Spannungsmodell. Die in der Maschine und dem Strommodell IMOD auftretende Komponente $EF1_\sim$ hat wegen ihrer hohen Frequenz praktisch keine Phasenverschiebung gegenüber der eingeprägten Hochfrequenzkomponente $IF1_\sim$. Dies gilt auch für den ohmschen Spannungsanteil im Spannungsmodell UMOD, so daß im Spannungsmodell ein gegenüber der Hochfrequenz-Komponente $IF1_\sim$ um 90° phasenverschobener Anteil in der Hochfrequenz-Komponente $EF1'_\sim$ nur durch eine Fehleinstellung des Parameters $x_{St}$ verursacht werden kann. Dieser Anteil ist dabei direkt proportional zur Fehleinstellung von $X_{St}$. Wird daher die Komponente $IF1_\sim$ in einem Phasendreher PD um 90° gedreht, so entspricht das in einem Multiplizierer PP9 gebildete Produkt $IF1'_\sim \cdot EF1'_\sim$ dem gegenüber der Hochfrequenz-Komponente um 90° phasenverschobenen Anteil des Modellkomponenten-Sollwertes, der über ein weiteres Tiefpaßfilter TP3 als Parameterfehler $dx_{St}$ dem als Einstellungseinrichtung dienenden Korrekturregler CR2 im Spannungsmodell zugeführt werden kann.

Der Vorteil dieses Verfahrens, das mit einer der flußparallelen Ständerstromkomponente aufgeprägten harmonischen (d.h. sinusförmigen) hochfrequenten Modulationsschwingung arbeitet, ist gegenüber einem Verfahren, das zur Identifizierung des Läuferwiderstandes niederfrequente und/oder pulsförmige Testsignale verwendet:

1. Der Fluß bleibt nahezu konstant, so daß sich das Testsignal praktisch nicht auf das Drehmoment auswirkt, die Steuerung der Maschine wird beim Anlauf also auch nach dem Start nicht beeinflußt.

2. Die auszuwertende Komponente $EF1'_\sim$ ist direkt proportional zum Läuferwiderstand.

3. Ein Fehler des nicht genau bekannten Ständerwiderstandes $r_S$ wird mit zunehmender Frequenz des Testsignals geringer, da sich die Stromverdrängung im Läufer stärker bemerkbar macht als im Ständer.

4. Der Einfluß der Streuinduktivität kann unterdrückt werden.

Die Folge der unterschiedlichen Stromverdrängung im Läufer und im Ständer wirkt allerdings störend, da die Größe $\overline{EF1'}$, die im ständerbezogenen Spannungsmodell errechnet ist, mit dem Läuferwiderstand $r_R$ (T, F = FM) korreliert ist, die bei der Temperatur T und einer Frequenz F der feldparallelen Stromkomponente IF1 auftritt, die gleich der Frequenz FM der modulierenden Hochfrequenzkomponente ist. Das Spannungsmodell identifiziert also den Sollwert des Wechselstromwiderstandes. Für die im Strommodell nachgebildeten physikalischen Vorgänge spielt aber der Widerstand $r_R$(T, F = FR) eine Rolle, der bei der Temperatur T und bei einer Frequenz F, die gleich der Schlupffrequenz FR (d.h. der Differenz zwischen der Frequenz des Modell-Flußvektors und der auf elektrische Frequenzen umgerechneten Läuferdrehzahl N) auftritt. Das Strommodell berücksichtigt also praktisch den Gleichstromwiderstand des Läufers. Damit im Differenzsignal DE für die beiden Größen $\overline{EF1}$ und $\overline{EF1'}$ die gleichen Größen miteinander verglichen werden, ist also eine Funktion

$$\frac{r_R(T,F=FM)}{r_R(T,F=FR)} = k_R (T, FM, FR)$$

zu berücksichtigen. Dabei kann praktisch FR = 0 gesetzt werden.

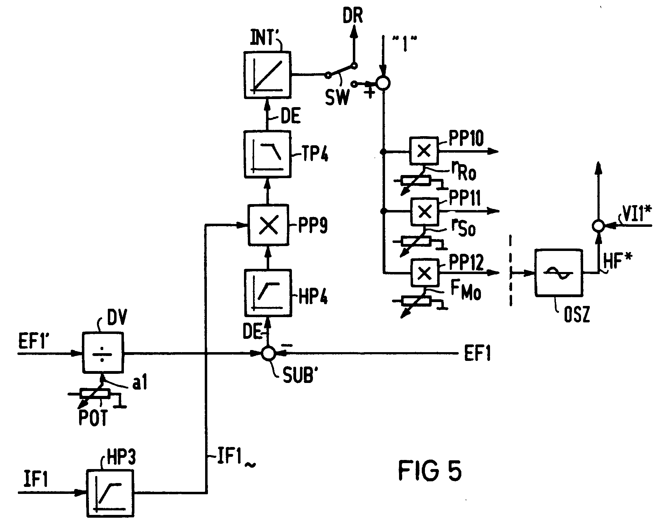

Bei der Auswerteeinheit nach Fig. 5 ist dieser Quotient durch eine entsprechende "Stromverdrängungsfunktion" al berücksichtigt, die einem Dividierer DV für den der Größe $\overline{EF1'}$ zugeordneten Wechselstromwiderstand aufgeschaltet ist.

Der Vergleich mit Fig. 4 zeigt, daß in der Auswerteschaltung die Isolierung der zu $IF1_\sim$ gleichphasigen Hochfrequenzanteile $\overline{EF1}$ und $\overline{EF1'}$ und deren Differenzbildung prinzipiell vertauschbar sind, so daß letztlich im Subtraktionsglied SUB' die Differenz DE' = EF1'-EF1 und in der nachgeschalteten Reihenschaltung eines Hochpaßfilters HP4, eines Multiplizierers PP9 und eines Tiefpaßfilters TP4 des Eingangssignals DE für den Korrekturregler CR1 gebildet wird, der hier als Integrator INT' ausgebildet ist und das Ausgangssignal DR liefert.

Zunächst kann bei der Temperatur $T_0$ der kalten Maschine aus Wertetabellen, die z.B. häufig vom Hersteller fabrikmäßig angegeben sind, jeweils der zugehörige Wert $r_{R0}$ und $r_{S0}$ der Gleichstromwiderstände festgestellt und zusammen mit dem Startwert FM0 der Modulationsfrequenz als Faktoren an Verstärkern PP10, PP11 und PP12 eingestellt werden. Solange der Korrekturregler INT' außer Eingriff ist (z.B indem sein Ausgangssignal DR über einen Umschalter SW aus der Schaltung herausgeführt wird) oder den Wert DR = 0 liefert, wird ein Oszillator OSZ mit dem Startwert FM0 (z.B. 80 Hz) angesteuert und liefert den harmonischen Zusatz-Sollwert HF*, der zusammen mit dem Stromkomponenten-Sollwert VI1* die zu VF(s) senkrechte Komponente IF1 des Stromvektors bildet. Die an PP10 und PP11 abgegriffenen Parameter $r_{R0} = r_R(T = T_0, F = 0)$ und $r_{S0}$ werden dem Strommodell und dem Spannungsmodell eingegeben. Im Anfangszustand ($T = T_0$, unbelastete und stillstehende Maschine) ist der mit NF* bzw. IF1~ korrelierte Anteil $\overline{EF1}$ der im Strommodell errechneten EMK-Komponente EF1 vom Gleichstromwiderstand $r_R(T = T_0, F = 0)$ bestimmt, der entsprechend korrelierte Anteil $\overline{EF1'}$ des im Spannungsmodell errechneten EMK-Komponentensollwertes EF1' aber mit dem Wechselstromwiderstand $r_R(T = T_0, F = FM0)$. Die Differenz DE = $(\overline{EF1'}/a_1) - \overline{EF1}$ wird also zu Null, wenn am Potentiometer P0T der Stromverdrängungsfaktor

$$a_1 = \frac{r_e\,(T=T_0,\ F = FM0)}{r_R\,(T=T_0,\ F = 0)}$$

eingestellt und dem Dividierer DV für den Anteil EFI' zugeführt wird. Wird also $a_1$ variiert, bis das Eingangssignal DE des Integrators INT' beim Ausgangssignal DR = 0 verschwindet, so ist der Stromverdrängungsfaktor bei der Temperatur $T = T_0$ identifiziert.

Bei der Erwärmung der laufenden Maschine wächst nun der Gleichstromwiderstand $r_R(T, F = 0)$, der praktisch gleich dem im Strommodell benötigten Parameter $r_R(T, F = FR)$ gesetzt werden kann, und es ändert sich der Einfluß der Stromverdrängung, die den vom Spannungsmodell identifizierten Wechselstromwiderstand $r_R(T, F = FM)$ beeinflußt. Man kann aber die Änderung der Stromverdrängung unterdrücken, indem man die davon verursachte Änderung des Wechselstromwiderstandes durch eine entsprechende Zunahme der Modulationsfrequenz FM kompensiert. Für die Modulationsfrequenz wird also ein temperaturabhängiger Wert FM(T) derart gewählt, daß gilt

$$\frac{r_R(T, F=FM(T))}{r_R(T, F=0)} = const = a_1 = \frac{r_R(T=T0, F=FM0)}{r_R(T=T0, F=0)}$$

Bei dieser temperaturabhängigen Vorgabe einer variablen Frequenz für den Zusatzsollwert wird also aus der Stromverdrängungsfunktion der konstante Faktor $a_1$, der noch vor der betriebsbedingten Erwärmung der Maschine ermittelt werden kann.

Das Produkt (Leitfähigkeit · Frequenz) ist ungefähr temperaturunabhängig:

$$\frac{FM_0}{r_R(T=T_0,\ F=FM_0)} = \frac{FM(T)}{r_R(T,\ F=FM(T))},$$

und für die Wahl der temperaturabhängigen Frequenz FM(T) ergibt sich:

$$FM(T) = FM_0\,\frac{r_R(T, F=0)}{r_R(T=T_0, F=0)}$$

$$= FM_0\left(1 + \frac{r_R(T, F=0) - r_R(T=T_0, F=0)}{r_R(T=T_0, F=0)}\right) = FM_0 \cdot (1+DR)$$

EP 0 324 146 B1

Bei dieser Vorgabe der Frequenz F = FM(T) des Zusatz-Sollwertes HF* durch den Multiplizierer PP12 wird also am Muliplizierer PP10 für den identifizierten Läufer-Gleichstromwiderstand $r_R$ der Wert $r_R$ (T, F = PM(T)) = $r_{R0}(1 + DR)$ und für den identifizierten Ständerwiderstand $r_S$ am Multiplizierer PP11 der Wert

$$\frac{r_{S0}}{r_{R0}} \cdot r_R = r_{S0} \cdot (1 + DR)$$

dadurch gebildet, daß die Modulationsfrequenz F dem identifizierten Läuferwiderstand unter der Bedingung nachgeführt wird, daß der Quotient $a_1$ aus Modulationsfrequenz und Läuferwiderstand konstant bleibt.

Allerdings sind allzu hohe Modulationsfrequenzen nachteilig, da sie z.B. von den heute üblichen Umrichtern der Maschine nicht mehr exakt eingeprägt werden können und/oder bei einer digitalen Auswertung zu Zeitproblemen führen. Außerdem führen zu starke Schwankungen der Modulationsfrequenz dazu, daß eine Phasendrehung um 90°, die bei der Auswerteeinrichtung nach Fig. 4 zum Nachstellen des Streuinduktivitätsparameters $x_{St}$ verwendet wird, nicht mehr durch einfache, auf eine bestimmte Frequenz ausgelegte Anordnungen möglich ist.

**Patentansprüche**

1. Verfahren zum Ermitteln des Läuferwiderstandes einer Drehfeldmaschine, insbesondere auch im Stillstand oder bei niedriger Last, mittels eines von Stromwerten (VI(S)) und Spannungswerten (VU(S)) gespeisten Spannungsmodells (UMOD) und eines mit Stromwerten (VI(S)), einem aus der Läuferstellung (N) abgeleiteten Signals und einem Modell-Parameter ($r_R$) für den Läuferwiderstand der Maschine gespeisten Strom-Modells (IMOD) für die Maschine unter Verwendung einer mittels der beiden Modelle ermittelten Modell-Flußachse (VF(S))
   **gekennzeichnet durch** folgende Maßnahmen:
   a) Der Maschine wird ein einem Sollstrom-Vektor (VI*(S)) entsprechender Ständerstrom eingeprägt, dessen zur Modell-Flußachse (VF(S)) parallele Komponente eine sinusförmige Hochfrequenzkomponente (HF*) mit einer über der Nennfrequenz der Maschine liegenden Frequenz enthält,
   b) mittels des Strommodells wird eine zur Modell-Flußachse (VF(S)) parallele Modell-Komponente (EF1) des EMK-Vektors der Maschine errechnet, und
   c) durch Verstellen des Modell-Parameters für den Läuferwiderstand wird die mit der Hochfrequenz-Komponente korrelierte Abweichung (DE) der Modell-Komponente (EF1) von einem mittels des Spannungsmodell errechneten Modellkomponenten-Sollwerts (EF1') ausgeregelt. (Figur 1)

2. Verfahren nach Anspruch 1, **dadurch gekennzeichnet,** daß die mit der Hochfrequenz-Komponente (HF = IF1$_\sim$) korrelierte Abweichung aus den jeweils zur Hochfrequenz-Komponente (IF1$_\sim$) gleichphasi-gen Anteilen ($\overline{EF1}$, $\overline{EF1'}$) der Modell-Komponente (EF1) und des Modellkomponenten-Sollwertes (EF1') gebildet wird. (Figur 4)

3. Verfahren nach Anspruch 2, **dadurch gekennzeichnet,** daß die gleichphasigen Anteile ($\overline{EF1}$, $\overline{EF1'}$) der Modell-Komponente und des Modell-Komponenten-Sollwertes durch Multiplikation mit der Hochfre-quenzkomponente (HF = IF1$_\sim$) gebildet werden. (Figur 4)

4. Verfahren nach Anspruch 1, **dadurch gekennzeichnet,** daß die Frequenz (FM) der HochfrequenzKomponente (HF*) derart nachgeführt wird, daß das Verhältnis von Gleichstrom-Widerstand des Läufers zum Widerstand bei der Frequenz der Hochfrequenz-Komponente temperaturunabhängig ist. (Figur 5)

5. Verfahren nach Anspruch 1, **dadurch gekennzeichnet,** daß im Spannungsmodell ein Parameterwert für die Streuinduktivität solange nachgestellt wird, bis ein mit der um 90° phasenverschobenen Hochfrequenz-Komponente (IF1') korrelierter Anteil ($\overline{EF1''}$) des Modellkomponenten-Sollwertes (EF1') verschwindet. (Fig. 4)

6. Verfahren nach Anspruch 1, **dadurch gekennzeichnet,** daß der Sollstrom-Vektor in einem auf die Modell-Flußachse orientierten Koordinatensystem vorgegeben und die zur Modell-Flußachse parallele Komponente des Sollstrom-Vektors mittels eines sinusförmigen hochfrequenten Zusatz-Sollwertes moduliert wird, daß mittels einer unterlagerten Stromregelung und mindestens einer von der Modell-Flußachse abhängigen Koordinatentransformation die Steuergrößen für einen Umrichter gebildet wer-

7

den und der Umrichter der Ständerwicklung der Drehfeldmaschine einen dem Sollstrom-Vektor und dem Zusatz-Sollwert entsprechenden Ständerstrom einspeist.

7.  Vorrichtung zur Durchführung des Verfahrens nach Anspruch 1 mit folgenden Merkmalen:

a) An einen Stromrichter (SR) ist die Ständerwicklung einer Asynchronmaschine (ASM) angeschlossen,

b) die Ventile des Stromrichters werden von einer Regeleinrichtung angesteuert, der Sollwerte (IF1*, IF2*) für die zum Fluß der Maschine parallele und senkrechte Komponente eines Ständerstromvektors und ein Signal (VF(S)) für die Lage des Flusses zugeführt sind,

c) der Ausgang eines harmonischen Oszillators (OSZ) ist als Zusatz-Sollwert (HF*) dem Sollwert (IF1*) für die zum Fluß der Maschine parallele Komponente des Ständerstromvektors aufgeschaltet,

d) einem Spannungsmodell-Rechner (UMOD), der an den Ausgang eines Spannungsdetektors (UDET) angeschlossen ist und dem die Werte des vom Stromrichter gesteuerten Ständerstroms der Maschine und das Signal für die Lage des Flusses Zugeführt sind, ist an seinem Ausgang mit einem Sollwert-Eingang einer Auswerteeinrichtung (AE) angeschlossen,

e) ein Strommodell-Rechner (IMOD), der einen an eine Erfassungseinrichtung (NM) für die Lage des Läufers angeschlossenen Eingang und einen Eingang besitzt, dem ebenfalls Werte (VI(S)) des Ständerstroms zugeführt sind, ist mit seinem Ausgang an den Istwert-Eingang der Auswerteeinrichtung (AE) angeschlossen,

f) in der Auswerteeinrichtung (AE) sind Mittel vorgesehen, um die mit dem Ausgangssignal (HF*) des Hochfrequenzoszillators korrelierten hochfrequenten Anteile der am Sollwerteingang und am Istwerteingang empfangenen, zum Fluß parallelen Komponente von in den Rechnern errechneten EMK-Vektoren zu isolieren,

g) am Ausgang der Auswerteeinrichtung AE ist ein erster Korrekturregler (CR1) angeordnet, dem die Differenz der isolierten Anteile zugeführt ist und dessen Ausgangssignal als Parameterwert für den Läuferwiderstand der Drehfeldmaschine abgegriffen und im Strommodell-Rechner (IMOD) verarbeitet wird.

8.  Vorrichtung nach Anspruch 7, **dadurch gekennzeichnet,** daß das Signal für die Lage des Flusses an einem Ausgang des Strommodell-Rechners abgegriffen und zusätzlich zum entsprechenden Eingang der Regeleinrichtung (REG) auch einem am Ausgang des Spannungsmodell-Rechners (UMOD) angeordneten Vektordreher zugeführt ist.

9.  Vorrichtung nach Anspruch 7, **dadurch gekennzeichnet,** daß die den vom Stromrichter (SR) gesteuerten Strömen entsprechenden Werte (VI(S)) am Ausgang eines Stromdetektors (IDET) abgegriffen und sowohl den entsprechenden Eingängen des Strommodell-Rechners (IMOD) und des Spannungsmodell-Rechners (UMOD) sowie Istwerteingängen von Stromreglern (IR1, IR2) der Regeleinrichtung zugeführt sind.

10.  Vorrichtung nach Anspruch 7, **dadurch gekennzeichnet,** daß die Auswerteeinrichtung (AE) einen weiteren, an den Spannungsmodell-Rechner (UMOD) angeschlossenen Ausgang besitzt, an dem ein weiterer Parameter der Maschine abgegriffen ist.

11.  Vorrichtung nach Anspruch 7, **gekennzeichnet durch** Mittel zur Erfassung der mit dem Ausgangssignal (HF*) des Oszillators (OSZ) korrelierten Komponente in dem zum Fluß parallelen Anteil des Ständerstroms und jeweils dem Sollwert-Eingang und dem Istwert-Eingang nachgeschaltete Hochpaß-Filter und Multiplizierer, die die an den Eingängen empfangenen Komponenten mit dem korrelierten Anteil des Ständerstroms multiplizieren.

12.  Vorrichtung nach Anspruch 10 und 11, **dadurch gekennzeichnet,** daß das Ausgangssignal des ersten Korrekturreglers (CR1) über einen Multiplizierer zum weiteren Ausgang der Auswerteeinrichtung geführt ist.

13.  Vorrichtung nach Anspruch 10 und 11, **dadurch gekennzeichnet,** daß über den weiteren Ausgang der Auswerteeinrichtung (AE) ein aus dem Komponenten-Sollwert (EF1') gebildeter Wert einem zweiten Korrekturregler (CR2) am Eingang des Spannungsmodell-Rechners (UMOD) zugeführt ist, dessen Ausgangssignal den Parameter der Streuinduktivität angibt.

**14.** Vorrichtung nach Anspruch 7, **gekennzeichnet durch** einen Frequenzgeber, der die Frequenz des Oszillators (OSZ) in Abhängigkeit vom Modellkomponenten-Sollwert (EF1') derart nachstellt, daß der Quotient aus dem Läuferwiderstand bei der nachgestellten Frequenz des Oszillators zum Läuferwiderstand der Maschine bei Gleichstrom temperaturunabhängig ist.

**Claims**

**1.** Method for determining the rotor resistance of a rotating-field machine, in particular also in the resting state or with low load, by means of a voltage model (UMOD) fed by current values (VI(S)) and voltage values (VU(S)) and by means of a current model (IMOD) for the machine, fed with current values (VI(S)), with a signal derived from the rotor position (N) and with a model parameter ($r_R$) for the rotor resistance of the machine, using a model flux axis (VF(S)) determined by means of the two models, characterized by the following measures:

a) a stator current corresponding to a desired current vector (VI*(S)) is applied to the machine, the component of the stator current parallel to the model flux axis (VF(S)) containing a sinusoidal high-frequency component (HF*) with a frequency lying above the nominal frequency of the machine,

b) by means of the current model a model component (EF1) of the EMF vector of the machine is calculated, the model component being parallel to the model flux axis (VF(S)), and

c) by adjusting the model parameter for the rotor resistance the deviation (DE) of the model component (EF1), correlated with the high-frequency component, from a model-component desired value (EF1'), calculated by means of the voltage model, is compensated. (Figure 1)

**2.** Method according to claim 1,
characterized in that the deviation, correlated with the high-frequency component ($HF = IF1_\sim$) is formed from the portions ($\overline{EF1},\overline{EF1'}$) of the model component (EF1) and of the model-component desired value (EF1') which are respectively in phase with the high-frequency component ($IF1_\sim$). (Figure 4)

**3.** Method according to claim 2,
characterized in that the in-phase portions ($\overline{EF1},\overline{EF1'}$) of the model component and of the model-component desired value are formed through multiplication with the high-frequency component ($HF = IF1_\sim$). (Figure 4)

**4.** Method according to claim 1,
characterized in that the frequency (FM) of the high-frequency component (HF*) is corrected in such a way that the ratio of direct-current resistance of the rotor to the resistance at the frequency of the high-frequency component is independent of temperature. (Figure 5)

**5.** Method according to claim 1,
characterized in that in the voltage model a parameter value for the leakage inductance is adjusted until a portion ($\overline{EF1''}$) of the model-component desired value (EF1') disappears, the portion being correlated with the high-frequency component (IF1') out of phase by 90°. (Figure 4)

**6.** Method according to claim 1,
characterized in that the desired-current vector is specified in a coordinate system oriented to the model flux axis and the component of the desired-current vector parallel to the model flux axis is modulated by means of a sinusoidal high-frequency additional desired value, in that by means of an underlying current regulation and at least one coordinate transformation dependent on the model flux axis, the control variables for a converter are formed and the converter of the stator winding of the rotating-field machine feeds in a stator current corresponding to the desired-current vector and the additional desired value.

**7.** Device for carrying out the method according to claim 1 with the following features:

a) the stator winding of an asynchronous machine (ASM) is attached to a power converter (SR),

b) the valves of the power converter are controlled by a regulating device, to which there are supplied desired values (IF1*, IF2*) for the component of a stator current vector parallel and perpendicular to the flux of the machine and a signal (VF(S)) for the position of the flux,

c) the output of a harmonic oscillator (OSZ) is applied as additional desired value (HF*) to the desired value (IF*) for the component of the stator current vector parallel to the flux of the machine,

d) a voltage-model computer (UMOD), which is attached to the output of a voltage detector (UDET) and to which are supplied the values of the stator current of the machine controlled by the power converter and the signal for the position of the flux, is attached at its output to a desired-value input of an evaluation device (AE),

e) a current-model computer (IMOD) which has an input attached to a detection device (NM) for the position of the rotor and an input to which values (VI(S)) of the stator current are likewise supplied, is attached with its output to the actual-value input of the evaluation device (AE),

f) in the evaluation device (AE) means are provided in order to insulate the high-frequency portions, correlated with the output signal (HF$^*$) of the high-frequency oscillator, of the component received at the desired-value input and at the actual-value input and parallel to the flux, from EMF vectors calculated in the computers,

g) at the output of the evaluation device AE a first correction regulator (CR1) is arranged, to which is supplied the difference of the insulated portions, and the output signal of which is picked up as parameter value for the rotor resistance of the rotating-field machine and is processed in the current-model computer (IMOD).

8. Device according to claim 7,
characterized in that the signal for the position of the flux is picked Up at an output of the current-model computer and in addition to the corresponding input of the regulating device (REG) is also supplied to a vector rotator arranged at the output of the voltage-model computer (UMOD).

9. Device according to claim 7,
characterized in that the values (VI(S)) corresponding to the currents controlled by the power converter (SR) are picked up at the output of a current detector (IDET) and are supplied both to the corresponding inputs of the current-model computer (IMOD) and of the voltage-model computer (UMOD) as well as to the actual-value inputs of current regulators (IR1, IR2) of the regulating device.

10. Device according to claim 7,
characterized in that the evaluation device (AE) has a further output attached to the voltage-model computer (UMOD), at which output a further parameter of the machine is picked up.

11. Device according to claim 7,
characterized by means for the detection of the component correlated with the output signal (HF$^*$) of the oscillator (OSZ) in the portion of the stator current parallel to the flux, and by high-pass filters and multipliers subsequently connected to the desired-value input and the actual-value input respectively, which multiply the components received at the inputs with the correlated portion of the stator current.

12. Device according to claim 10 and 11,
characterized in that the output signal of the first correction regulator (CR1) is guided by way of a multiplier to the further output of the evaluation device.

13. Device according to claim 10 and 11,
characterized in that by way of the further output of the evaluation device (AE) a value formed from the component desired value (EF1') is supplied to a second correction regulator (CR2) at the input of the voltage-model computer (UMOD), the output signal of which indicates the parameter of the leakage inductance.

14. Device according to claim 7,
characterized by a frequency generator, which adjusts the frequency of the oscillator (OSZ) in dependence upon the model-component desired value (EF1') in such a way that the ratio of the rotor resistance with the adjusted frequency of the oscillator to the rotor resistance of the machine with direct current is independent of temperature.

**Revendications**

1. Procédé pour déterminer la résistance du rotor d'une machine à induction, notamment également à l'arrêt ou sous une faible charge, à l'aide d'un système modèle de calcul de la tension (UMOD), alimenté par des valeurs de courant (VI(S)) et des valeurs de tension (VU(S)), et d'un système modèle de calcul du courant (IMOD) alimenté par des valeurs de courant (VI(S)), par un signal dérivé de la position (N) du rotor et par un paramètre ($r_R$) du modèle pour la résistance du rotor de la machine, pour la machine moyennant l'utilisation d'un axe de flux (VF(s)) déterminé à l'aide des deux systèmes modèles,

caractérisé par les dispositions suivantes :

a) un courant statorique, qui correspond à un vecteur (VI*(s)) du courant de consigne et dont la composante parallèle à l'axe de flux (VF(S)) du système modèle contient une composante sinusoïdale à haute fréquence (HF*) posséddant une fréquence supérieure à la fréquence nominale de la machine, est injecté dans cette dernière,

b) une composante de modèle (EF1), parallèle à l'axe de flux (VF(S)) du système modèle, du vecteur force électromotrice de la machine est calculée par le système modèle de calcul du courant, et

c) au moyen du réglage du paramètre de modèle pour la résistance du rotor, l'écart (DE), corrigé au moyen de la composante à haute fréquence, entre la composante de module (EF1) et une valeur de consigne (EF1') de la composante de modèle, calculée à l'aide du système modèle de calcul de la tension, est éliminé par réglage (figure 1).

2. Procédé selon la revendication 1, caractérisé par le fait que l'écart, corrélé à la composante à haute fréquence (HF = IF1~), entre les composantes ($\overline{EF1}$, $\overline{EF1'}$), en phase respectivement avec la composante à haute fréquence (IF1~), de la composante de modèle (EF1) et de la valeur de consigne (EF1') de la composante de modèle, est formé. (Figure 4).

3. Procédé suivant la revendication 2, caractérisé par le fait que les composantes en phase ($\overline{EF1}$, $\overline{EF1'}$) de la composante de modèle et de la valeur de consigne de la composante de modèle sont formées par multiplication par la composante à haute fréquence (HF = IF1~). (Figure 4).

4. Procédé suivant la revendication 1, caractérisé par le fait que la fréquence (FM) de la composante à haute fréquence (HF*) est asservie de telle sorte que le rapport de la résistance en courant continu du rotor à la résistance pour la fréquence de la composante à haute fréquence, est indépendant de la température. (Figure 5).

5. Procédé suivant la revendication 1, caractérisé par le fait que dans le modèle de tension, une valeur de paramètre pour l'inductance de fuite est réglée par asservissement jusqu'à ce qu'une partie ($\overline{EF1''}$), corrélée à la composante à haute fréquence (IF1') déphasée de 90°, de la valeur de consigne (EF1') de la composdante de modèle disparaissent. (Figure 4).

6. Procédé suivant la revendication 1, caractérisé par le fait que le vecteur du courant de consigne est prédéterminé dans un système de coordonnées orienté sur l'axe de flux du modèle et que la composante, parallèle à l'axe de flux du modèle, du vecteur du courant de consigne est modulée au moyen d'une valeur de consigne sinusoïdale supplémentaire à haute fréquence, que les grandeurs de commande pour un mutateur sont formées à l'aide d'une régulation subordonnée du courant et au moins d'une transformation de coordonnées, qui dépend de l'axe de flux du modèle, et que le mutateur de l'enroulement statorique de la machine à induction introduit un courant statorique correspondant au vecteur du courant de consigne et à la valeur de consigne supplémentaire.

7. Dispositif pour la mise en oeuvre du procédé suivant la revendication 1, présentant les caractéristiques suivantes :

a) l'enroulement statorique d'une machine asynchrone (ASM) est raccordée à un convertisseur statique (SR),

b) les valves du convertisseur statique sont commandées par un dispositif de régulation auquel sont envoyés des valeurs de consigne (IF1*, IF2*) pour les composantes parallèle et perpendiculaire au flux de la machine, d'un vecteur de courant statorique, et un signal (VF(S)) pour la position du flux,

c) le signal de sortie d'un oscillateur harmonique (OSZ) est ajouté, en tant que valeur de consigne supplémentaire (HF*), à la valeur de consigne (IF1*) pour la composante, parallèle au flux de la machine, du vecteur du courant statorique,

d) une entrée de la valeur de consigne d'un dispositif d'évaluation (AE) est raccordée à la sortie d'un calculateur (UMOD) du modèle de tension, qui est raccordé à la sortie d'un détecteur de tension (UDET) et auquel sont envoyées les valeurs du courant statorique de la machine, commandé par le convertisseur statique, et le signal de la position du flux,

e) un calculateur (IMOD) du système modèle de calcul du courant, qui possède une entrée raccordée à un dispositif (NM) de détection de la position du rotor et une entrée, à laquelle sont également envoyées des valeurs (VI(S)) du courant statique, est raccordé par sa sortie à l'entrée de valeurs réelles du dispositif d'évaluation (AE),

f) dans le dispositif d'évaluation (AE) il est prévu des moyens permettant d'isoler les composantes à haute fréquence, corrélées au signal de sortie (HF*) de l'oscillateur à haute fréquence, des composantes, qui sont reçues à l'entrée de valeurs de consigne et à l'entrée de valeurs réelles et sont parallèles aux flux, de vecteurs force électromotrice calculés dans les calculateurs,

g) à la sortie du dispositif d'évaluation (AE) est disposé un premier régulateur de correction (CR1), auquel est envoyée la différence des composantes isolées et dont le signal de sortie est prélevé en tant que valeur de paramètre pour la résistance du rotor de la machine à induction et est traité dans le calculateur (IMOD) du modèle de calcul du courant.

8. Dispositif selon la revendication 7, caractérisé par le fait que le signal de la position du flux est prélevé sur une sortie du calculateur du système modèle de calcul du courant et est envoyé non seulement à l'entrée correspondante du dispositif de régulation (REG), mais également à un dispositif de rotation vectorielle disposé à la sortie du calculateur (UMOD) du modèle de tension.

9. Dispositif suivant la revendication 7, caractérisé par le fait que les valeurs (VI(S)), qui correspondent aux courants commandés par le convertisseur statique (SR), sont prélevées à la sortie d'un détecteur de courant (IDET) et sont envoyées aussi bien aux entrées correspondantes du calculateur (IMOD) du modèle du calcul du courant et du calculateur (UMOD) du système modèle de calcul de la tension ainsi qu'à des entrées de valeurs réelles de régulateurs de courant (IR1, IR2) du dispositif de régulation.

10. Dispositif suivant la revendication 7, caractérisé par le fait que le dispositif d'évaluation (AE) possède une autre sortie, qui est raccordée au calculateur (UMOD) du système modèle de calcul de la tension et sur laquelle est prélevée un autre paramètre de la machine.

11. Dispositif suivant la revendication 7, caractérisé par des moyens pour détecter les composantes, corrélées au signal de sortie (HF*) de l'oscillateur (OSZ), dont la partie, parallèle aux flux, du courant statorique, et par des filtres passe-haut et des multiplicateurs, qui sont branchés respectivement en aval de l'entrée de la valeur de consigne et de l'entrée de la valeur réelle et qui multiplient les composantes reçues au niveau des entrées, par la partie corrélée du courant statorique.

12. Dispositif suivant les revendications 10 et 11, caractérisé par le fait que le signal de sortie du premier régulateur de correction (CR1) est raccordé, par un multiplexeur, à l'autre sortie du dispositif d'évaluation.

13. Dispositif suivant les revendications 10 et 11, caractérisé par le fait qu'une valeur, formée à partir de la valeur de consigne (EF1') d'une composante, est envoyée par l'intermédiaire de l'autre sortie du dispositif d'évaluation (AE) à un second régulateur de correction (CR2) à l'entrée du calculateur (UMOD) du système modèle de calcul de la tension, dont le signal de sortie indique le paramètre de l'inductance de fuite.

14. Dispositif suivant la revendication 7, caractérisé par un générateur de fréquence, qui règle d'une manière asservie la fréquence de l'oscillateur (OSZ) en fonction de la valeur de consigne (EF1') de la composante de modèle de telle sorte que le quotient de la résistance du rotor lorsque la fréquence de l'oscillateur est asservie, à la résistance du rotor de la machine pour un courant continu est indépendant de la température.

FIG 1

FIG 2

FIG 3

FIG 4

14

FIG 5